# FASCICULE DE BREVET EUROPEEN

(11) **EP 2 737 781 B1**
(45) Date de publication et mention de la délivrance du brevet: **14.09.2016**
(21) Numéro de dépôt: 12719322.5
(22) Date de dépôt: 24.04.2012
(51) Int. Cl.: H05K 1/03, H01L 23/498

(54) **PROCEDE D'ASSEMBLAGE D'UN DISPOSITIF A PUCE MICRO-ELECTRONIQUE DANS UN TISSU, DISPOSITIF A PUCE, ET TISSU INCORPORANT UN DISPOSITIF A PUCE SERTI**
VERFAHREN ZUR MONTAGE EINER VORRICHTUNG MIT EINEM MIKROELEKTRONISCHEN CHIP IN EINER FASER, CHIPVORRICHTUNG UND FASER MIT DER EINGEPRESSTEN CHIPVORRICHTUNG
METHOD FOR ASSEMBLING MICROELECTRONIC-CHIP DEVICE IN FABRIC, CHIP DEVICE, AND FABRIC CONTAINING A CRIMPED CHIP DEVICE

(30) Priorité: 28.07.2011 FR 1102372; 16.11.2011 FR 1103487
(43) Date de publication de la demande: 04.06.2014
(73) Titulaire: Commissariat à l'Énergie Atomique et aux Énergies Alternatives, 75015 Paris (FR); Pôle Européen de Plasturgie, 01100 Bellignat (FR)
(72) Inventeur: BRUN, Jean, F-38800 Champagnier (FR); CHRISTOPHE, Delphine, F-69510 Thurins (FR); TENCHINE, Lionel, F-38500 Coublevie (FR)
(74) Mandataire: Novaimo
(86) Numéro de dépôt international: PCT/EP2012/057490
(87) Numéro de publication internationale: WO 2013/013843

(56) Documents cités:
- EP-A2- 2 107 642
- WO-A1-03/052875
- US-A1- 2003 199 160
- US-A1- 2010 238 637
- US-A1- 2011 100 683

## Description

### Domaine technique de l'invention

L'invention est relative à un procédé d'assemblage d'un dispositif à puce microélectronique dans un tissu.

### État de la technique

De nombreuses techniques existent aujourd'hui pour connecter mécaniquement et électriquement des puces microélectroniques entre elles. Une technique classique consiste, une fois les puces formées sur un substrat, et libérées par sciage, à réaliser une connexion mécanique rigide entre les puces. Les puces, alors fixées sur un support rigide, sont ensuite connectées électriquement avant qu'un enrobage de protection ne soit formé. Cette approche, consistant à réaliser la connexion sur un support rigide, est classiquement utilisée lorsqu'il existe une grande complexité dans la connexion des puces. Cependant, cette dernière a pour principal inconvénient d'utiliser un support mécanique rigide qui est particulièrement mal adapté à une intégration dans des structures souples.

Le document WO2008/025889 de la demanderesse décrit, comme l'illustre la figure 1, une puce microélectronique comportant deux faces principales parallèles 1, 2 et des faces latérales 3a, 3b reliant les faces principales 1, 2. Chacune des faces latérales 3a, 3b comporte une rainure 4, munie d'un élément de connexion électrique (non représenté), et formant un logement pour un élément filaire 5 ayant un axe parallèle à l'axe longitudinal de la rainure 4. L'élément de connexion électrique est réalisé par métallisation de la rainure 4.

L'élément filaire 5, dont l'axe est parallèle à l'axe longitudinal de la rainure 4, peut être solidarisé à la rainure 4 par soudure avec apport de matériau, par électrolyse, par collage, ou par encastrement. Ces méthodes de solidarisation sont complexes à mettre en oeuvre compte tenu de la petite taille des dispositifs à puce.

Les paires de fils ainsi munies de dispositifs à puce peuvent ensuite être tissées avec d'autres fils pour former un tissu. Ceci nécessite certaines précautions lors de la manipulation pendant le tissage, afin de ne pas arracher les dispositifs à puce.

Un procédé d'assemblage d'un dispositif à puce microélectronique dans un tissu est aussi décrit dans le document US 2010/238637.

### Résumé de l'invention

On cherche ainsi à incorporer de manière simple des dispositifs à puce électronique dans un tissu sans exiger de précautions lors du tissage. Pour cela, on cherche en particulier à réaliser un dispositif à puce qui puisse être incorporé de manière aisée dans un tissu fini.

On satisfait ce besoin à l'aide des étapes suivantes :
- prévoir un dispositif à puce micro-électronique comprenant une embase et un élément en saillie s'élevant d'une face de l'embase, ledit élément en saillie comprenant une extrémité libre opposée à l'embase,
- insérer dans le tissu, à partir d'une face du tissu, le dispositif à puce par l'extrémité libre de l'élément en saillie,
- déformer l'élément en saillie au niveau de son extrémité libre de sorte à former un bourrelet de sertissage afin d'assurer le maintien du dispositif à puce avec le tissu après déformation.

Selon une mise en oeuvre le dispositif à puce comporte une borne de connexion électrique reliée à la puce, et le tissu comporte un fil électriquement conducteur, ledit fil électriquement conducteur étant amené en contact électrique avec la borne de connexion lors de l'insertion du dispositif à puce dans le tissu, et étant maintenu en contact avec la borne de connexion consécutivement à l'étape de déformation de l'élément en saillie. Avantageusement, l'étape de déformation est réalisée en reportant, de part et d'autre du dispositif à puce, deux platines pour appliquer via ces platines un effort de compression axial sur l'élément en saillie entre son extrémité libre et sa jonction avec l'embase.

Selon une variante, l'élément en saillie est formé, au moins au niveau de son extrémité libre, par un matériau thermodéformable, et une des platines est placée en contact avec l'extrémité libre de l'élément en saillie, ou en contact avec une face de tissu séparée de l'extrémité libre par une portion de tissu, pour venir chauffer ladite extrémité libre au cours de l'étape de déformation. L'autre platine peut être placée en contact avec l'embase sur une face de l'embase opposée à la face de l'embase sur laquelle s'élève l'élément en saillie, cette autre platine étant refroidie lors de l'étape de déformation.

Selon un mode de réalisation, le tissu comporte deux fils électriquement conducteurs et sensiblement parallèles, et l'élément en saillie présente une forme pénétrante, le long d'un axe perpendiculaire au plan de l'embase, définie au moins par l'extrémité libre de l'élément en saillie ayant une dimension inférieure à l'écartement des fils, l'étape d'insertion du dispositif à puce dans le tissu comportant les sous-étapes suivantes :
- placer l'extrémité libre de l'élément en saillie entre les deux fils,
- déplacer le dispositif à puce entre les deux fils d'où il résulte que les fils sont écartés par la forme pénétrante de l'élément en saillie,
- continuer le déplacement du dispositif à puce jusqu'à ce que les deux fils viennent chacun en contact électrique avec une borne de connexion associée du dispositif à puce.

Selon une mise en oeuvre, la forme de l'élément en saillie est conique, et l'élément en saillie comporte un filetage à deux filets, le procédé comprenant lors de l'étape d'insertion les étapes suivantes :
- mettre les filets en prise avec deux fils du tissu, et
- appliquer un mouvement de vissage au dispositif à puce. Avantageusement, l'étape de déformation comporte :
   - le maintien du dispositif à puce dont l'élément en saillie traverse le tissu,
   - la déformation par voie ultrasonore de l'extrémité libre de l'élément en saillie.

Avantageusement, le dispositif à puce comporte une borne de connexion électrique reliée à la puce, et le tissu comporte un fil électriquement conducteur, ledit procédé comportant une étape d'interposition d'un polymère destiné à assurer un contact électrique entre le fil et la borne de connexion électrique. Dès lors selon une variante, le polymère peut comprendre des particules électriquement conductrices, et le procédé peut comporter : une étape de sollicitation du fil contre la borne de connexion électrique pour pincer au moins une particule, ou un agglomérat de particules, entre la borne de connexion et le fil ; et une étape de solidification du polymère pour assurer un maintien mécanique entre le fil, le polymère solidifié et la borne de connexion.

Le dispositif à puce peut être une diode électroluminescente configurée pour émettre de la lumière par le sommet du bourrelet de sertissage, et dans ce cas l'étape de déformation comporte une étape de conformation du bourrelet de sertissage sous une forme de lentille optique

L'invention est aussi relative à un dispositif à puce comportant une embase au niveau de laquelle s'élève un élément en saillie, l'élément en saillie a une extrémité libre opposée à l'embase, et l'élément en saillie est formé, au moins au niveau de son extrémité libre, par un polymère thermoplastique ou thermodurcissable, ou par un matériau dont la température de fusion est comprise entre 70°C et 320°C

Selon une variante, le dispositif comporte au moins une borne de connexion formée dans l'élément en saillie.

L'invention est aussi relative à un tissu comprenant au moins un dispositif à puce serti au niveau du tissu par un bourrelet de sertissage. Le tissu peut être étanche, et au niveau du dispositif à puce, l'étanchéité est garantie au moins partiellement par le bourrelet de sertissage.

En outre, le tissu peut comporter un dispositif à puce muni d'une diode électroluminescente, et le bourrelet de sertissage peut être configuré de sorte à former une lentille optique par laquelle la lumière issue de la diode électroluminescente est émise.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une puce selon l'art antérieur.
La figure 2 illustre un mode de réalisation d'un dispositif à puce vu de côté.
La figure 3 illustre une vue en coupe du dispositif à puce de la figure 2 inséré dans un tissu.
La figure 4 illustre le dispositif à puce de la figure 2 serti dans avec le tissu.
La figure 5 illustre une variante du mode de réalisation de la figure 3.
La figure 6 illustre le sertissage de la variante de la figure 5.
La figure 7 illustre une variante d'un dispositif à puce équipé d'une borne de connexion, mis en place dans un tissu.
Les figures 8 à 12 illustrent des variantes de réalisation de dispositif à puce.
Les figures 13 et 14 illustrent schématiquement l'étape d'insertion d'un dispositif à puce dans un tissu.
Les figures 15 et 16 illustrent l'étape de déformation du dispositif à puce pour l'assembler avec le tissu selon une vue en coupe centrée sur le dispositif à puce.
La figure 17 illustre une variante d'un dispositif à puce utilisé dans le procédé.
La figure 18 illustre un tissu équipé de trois dispositifs à puce.
La figure 19 illustre un mode de réalisation particulier utilisant un polymère.

### Description de modes particuliers de réalisation

Comme on l'a précédemment indiqué, on cherche à réaliser un dispositif à puce micro-électronique qui soit facilement incorporable à un tissu. En d'autres termes, on n'aura pas besoin de solidariser les dispositifs à puce à des fils qui serviront par la suite à tisser, ou à former, le tissu dit « fini ».

En règle générale, un tissu est formé par des fils de chaîne sensiblement parallèles les uns aux autres, et par des fils de trame sensiblement parallèles les uns aux autres et croisant les fils de chaîne. Deux fils de chaîne consécutifs et deux fils de trame consécutifs forment une maille ayant le plus souvent une forme générale de parallélogramme, cette maille délimite un espace libre. Bien entendu, d'autres types de tissus et de mailles peuvent être envisagés. En effet, le tissu peut être tissé (fils de chaîne et de trame) ou non-tissé (agglomérat de fibres ou de fils compressés solidaires entre eux).

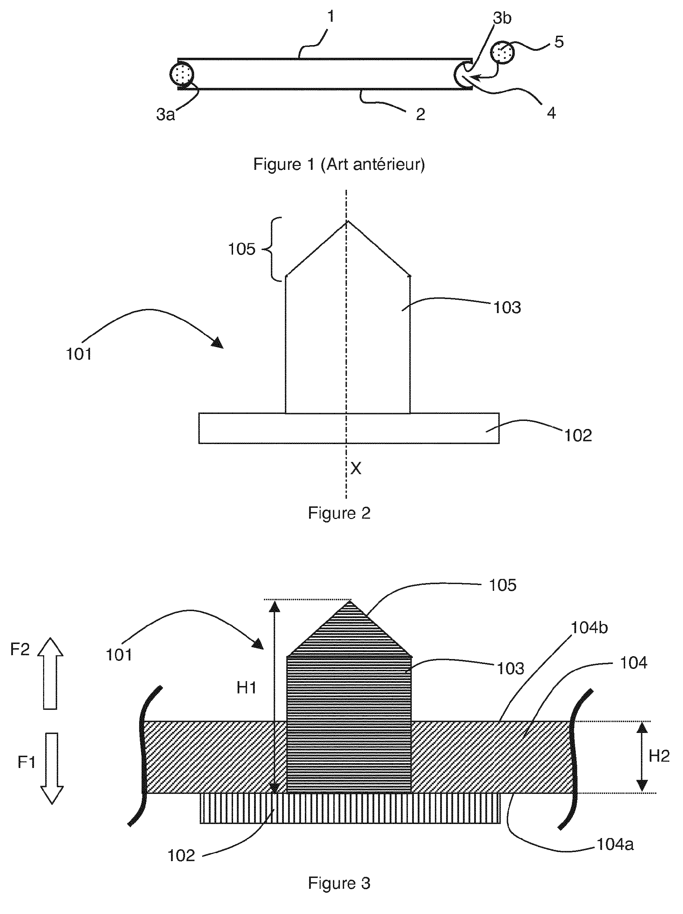

Sur la figure 2, un dispositif à puce 101 micro-électronique (ci-après identifié par dispositif à puce) comprend une embase 102 et un élément en saillie 103 s'élevant d'une face de l'embase 102. Préférentiellement, une partie de l'élément en saillie 103 possède un profil pénétrant, par exemple en forme de pointe, destiné à faciliter son insertion dans l'espace libre d'une maille d'un tissu, et à écarter les fils formant la maille sous une pression exercée sur le dispositif à puce 101. L'élément en saillie 103 comprend une extrémité libre 105 opposée à l'embase 102. Entre l'extrémité de l'élément en saillie 103 en contact avec l'embase 102 et l'extrémité libre 105 opposée, une direction axiale X de l'élément en saillie 103 est définie. Préférentiellement, selon cette direction axiale X, en partant de l'embase 102, soit les dimensions de la section de l'élément en saillie 103, dans un plan perpendiculaire à l'axe X sont invariantes (l'élément en saillie 103 forme alors un cylindre), soit elles convergent en direction du sommet de l'extrémité libre 105. En fait, dans le cadre d'une maille, si l'on veut favoriser l'insertion du dispositif à puce, le sommet de l'extrémité libre de l'élément en saillie 103 est de dimensions inférieures à celles de la maille. Pour favoriser le contact des fils de la maille avec le dispositif à puce 101, au moins une partie de l'élément en saillie 103 destinée audit contact de l'élément en saillie 103 avec lesdits fils a des dimensions supérieures à l'écartement des fils définissant la maille.

Sur la figure 3, le dispositif à puce 101 a été inséré, au cours d'une étape du procédé d'assemblage, par l'extrémité libre 105 de l'élément en saillie 103 dans un tissu 104. Cette insertion a été réalisée par une face 104a du tissu 104. De préférence, l'insertion est réalisée jusqu'à ce que l'embase 102 vienne en contact avec la face d'insertion 104a du tissu 104. De manière préférentielle, afin d'éviter la déformation du tissu 104 lors de l'insertion d'un dispositif à puce 101 par une face 104a d'un tissu 104, on reporte, avant l'insertion, une plaque sur une face 104b du tissu opposée à la face d'insertion 104a. Une fois l'insertion terminée cette plaque peut être retirée. Dans l'exemple de la figure 3, l'élément en saillie 103 traverse le tissu 104, c'est-à-dire que la hauteur H1 de l'élément en saillie 103 est supérieure à la hauteur H2 du tissu 104. Dès lors, si la plaque évoquée ci-dessus est utilisée, elle peut comporter une ouverture de sorte à permettre le passage de l'élément en saillie 103, ou être suffisamment souple pour être localement déformée par la pointe. Il résulte d'une telle insertion que le dispositif à puce 101 risque, selon un effort de traction F1 opposé à l'effort F2 nécessaire à son insertion, d'être désolidarisé du tissu. Dès lors, il résulte un besoin de maintenir l'assemblage entre le tissu 104 et le dispositif à puce 101.

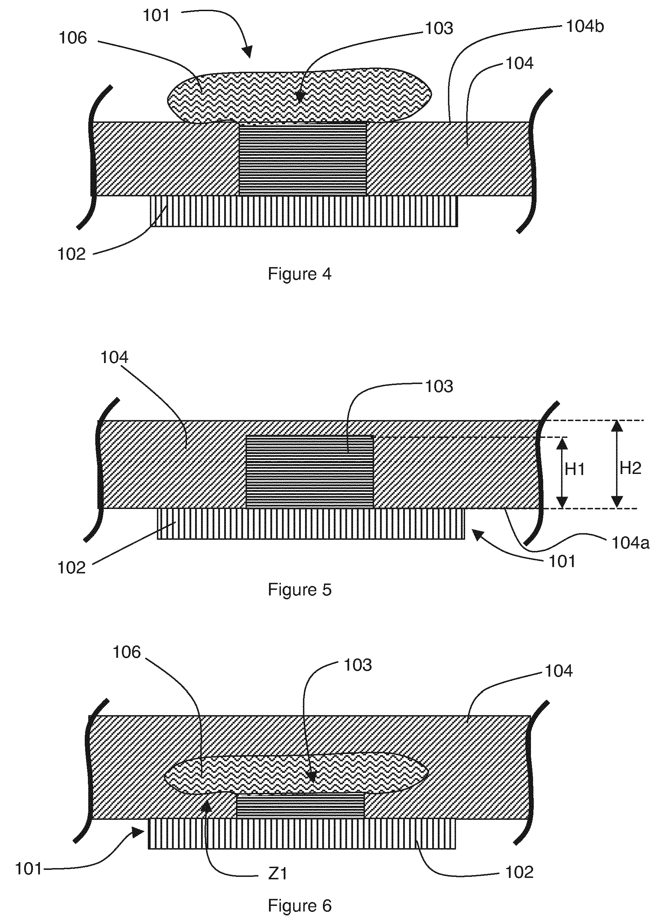

Sur la figure 4, ce besoin a été satisfait en prévoyant, après insertion, de déformer l'élément en saillie 103 au niveau de son extrémité libre 105 (figure 3) de sorte à assurer le maintien du dispositif à puce 101 avec le tissu 104 après déformation. Dans l'exemple particulier de la figure 4, le matériau constitutif de l'élément en saillie 103 s'est déformé (par exemple par fluage) de sorte à générer un bourrelet de sertissage 106 au niveau de la surface extérieure 104b du tissu 104 évitant le retrait du dispositif à puce 101. Autrement dit, le tissu 104 est pris, localement, en sandwich entre le bourrelet 106 et l'embase 102.

Selon une variante de réalisation illustrée à la figure 5, lors de l'insertion du dispositif à puce 101 dans le tissu 104, l'élément en saillie 103 ne traverse pas le tissu 104, même lorsque préférentiellement l'embase 102 est en contact avec la face 104a d'insertion. Autrement dit, la hauteur H1 de l'élément en saillie 103 est inférieure à l'épaisseur H2 du tissu 104. Dans ce cas, si l'on veut utiliser la plaque évoquée ci-dessus pour éviter la déformation du tissu 104 lors de l'insertion, cette dernière n'a pas besoin d'être ouverte. À la figure 5, l'extrémité libre de l'élément en saillie n'est pas en forme de pointe, cependant la variante en forme de pointe peut être mise en oeuvre. Sur la figure 6, la déformation de l'élément en saillie 103 permet, par exemple par fluage, de former un bourrelet 106 de sertissage dans le tissu 104, générant ainsi une accroche entre les fils, ou fibres, du tissu et le dispositif à puce 101. Ainsi, une portion du tissu 104 est prise dans sa hauteur en sandwich entre le bourrelet 106 et l'embase 102 au niveau d'au moins une zone Z1. Préférentiellement, lorsque la matière flue dans le tissu (figure 6) ou au dessus du tissu (figure 4), les fibres ou fils du tissu en contact avec le bourrelet 106 sont collées audit bourrelet 106, améliorant ainsi le phénomène d'anti-extraction de sorte à assurer un maintien amélioré du dispositif à puce avec le tissu.

Ainsi, on comprend que de manière générale, l'étape de déformation de l'élément en saillie 103 au niveau de son extrémité libre 105 permet de former un bourrelet de sertissage afin d'assurer le maintien du dispositif à puce 101 avec le tissu 104 après déformation.

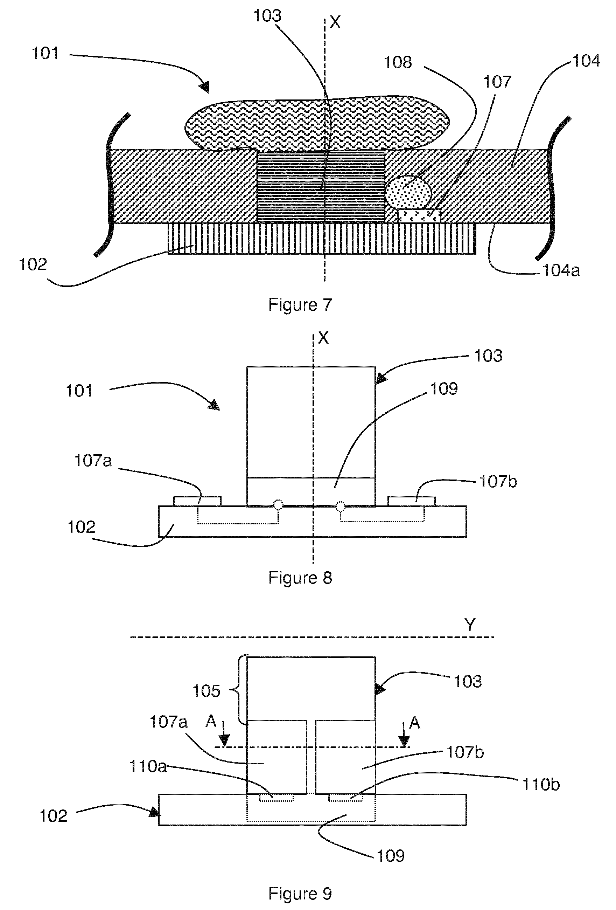

Sur la figure 7, avantageusement, le dispositif à puce 101 comporte une borne de connexion électrique 107 reliée à une zone active du dispositif à puce 101. Par zone active, on entend la puce équipant le dispositif à puce 101. Sur l'exemple particulier de la figure 7, la zone active peut être l'embase 102. Le tissu 104 comporte un fil électriquement conducteur 108, ledit fil électriquement conducteur 108 étant amené en contact électrique avec la borne 107 lors de l'étape d'insertion du dispositif à puce 101 dans le tissu 104. Ce contact est ensuite maintenu consécutivement à l'étape de déformation de l'élément en saillie 103, par exemple par une pression sur le tissu effectuée par le bourrelet 106 et l'embase 102.

En fait, dans la plupart des applications, on voudra connecter le dispositif à puce à d'autres dispositifs à puce, à un bus de données, à une alimentation électrique, à une antenne, etc., l'utilisation de bornes de connexion et de fils électriquement conducteurs permet de satisfaire ces besoins.

De préférence, une borne de connexion électrique 107 est située sur l'embase 102 sur la face portant l'élément en saillie 103 (figure 7), ou sur, voire dans, l'élément en saillie 103 lui-même. Des exemples seront décrits plus en détail ci-après.

Sur la figure 8, le dispositif à puce 101 comporte deux bornes de connexion 107a, 107b se présentant sous la forme de plots (« bumps » en anglais) disposés sur l'embase 102 de part et d'autre de l'élément en saillie 103. La puce 109 fait partie de l'élément en saillie 103, et est reliée à ces bornes 107a, 107b par un schéma électrique (représenté en pointillés) formé dans l'embase 102. La puce 109 pourrait aussi être incluse dans l'embase 102 comme dans l'exemple de la figure 7.

De manière applicable aux figures 7 et 8, le dispositif à puce 101 comporte au moins une borne de connexion.

Préférentiellement, l'élément en saillie s'élève de l'embase en laissant tout autour de sa jonction avec l'embase une surface libre de l'embase. Autrement dit, après déformation, l'élément en saillie forme un champignon. Cette forme permet, par exemple, au dispositif à puce de comporter quatre bornes de connexions réparties sur l'embase autour de l'élément en saillie (préférentiellement ces quatre bornes sont disposées selon quatre points cardinaux), de sorte à connecter électriquement et distinctement quatre fils électriquement conducteurs formant une maille dans laquelle l'élément en saillie est inséré. Les quatre fils sont alors maintenus en contact avec leurs bornes associées par un pincement mécanique entre le bourrelet de sertissage formant champignon et l'embase.

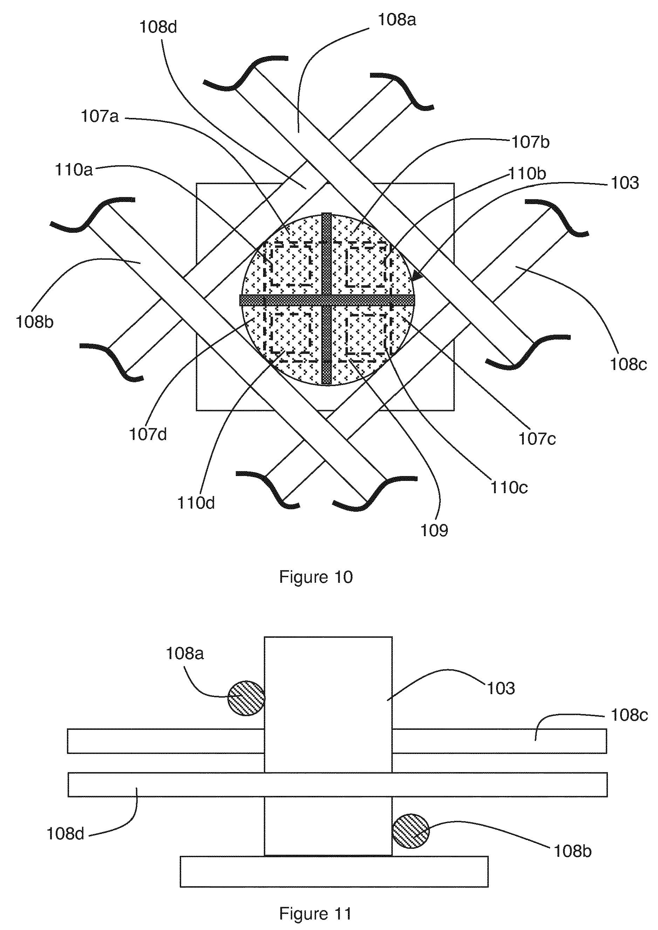

Sur la figure 9, la puce 109 est formée dans l'embase 102, ou peut être constituée par l'embase 102 (dans cet exemple la puce pourrait aussi être montée en saillie sur l'embase et former en partie l'élément en saillie 103), et deux bornes de connexions 107a, 107b distinctes sont formées par des portions associées de l'élément en saillie 103. Autrement dit, au moins une borne de connexion est formée dans l'élément en saillie. Les portions sont respectivement en contact électrique avec des zones de reprise de contact 110a, 110b de la puce 109. Le mode de la figure 9 permet avantageusement de mettre en contact deux fils électriquement conducteurs d'un tissu 104 avec la puce 109 lors de l'insertion du dispositif dans le tissu. Afin d'assurer un bon contact électrique, l'écart entre deux fils adjacents sera configuré de sorte que les deux fils enserrent l'élément en saillie 103 au niveau des bornes 107a, 107b après insertion. L'écartement des deux fils est alors réalisé de manière décalée le long de l'axe Y. Bien entendu, pour les besoins du procédé, ces bornes 107a et 107b sont surmontées par une zone déformable définissant l'extrémité libre 105. Cette zone déformable peut être formée par collage d'une pointe ductile (non représentée). Les bornes 107a, 107b peuvent être réalisées par photo masquage et électrolyse de cuivre ou de son alliage, ou encore de tout autre matériau électriquement conducteur facilement, déposable en couche épaisse. Selon une variante de la figure 9 illustrée à la figure 10 représentant une vue en coupe équivalente à la coupe selon A-A de la figure 9, l'élément en saillie 103 comporte quatre portions délimitant quatre bornes de connexion associées 107a, 107b, 107c, 107d (préférentiellement isolées électriquement les unes des autres), chacune de ces portions est en contact électrique avec une zone de reprise de contact 110a, 110b, 110c, 110d, associée de la puce 109. Cette variante de dispositif à puce est avantageusement insérée dans l'espace libre d'une maille de tissu tissé. Les quatre fils 108a, 108b, 108c, 108d définissant la maille sont électriquement conducteurs. Le procédé comporte alors l'insertion de l'élément en saillie 103 dans la maille, entre les quatre fils 108a, 108b, 108c, 108d la définissant, de sorte que chaque fil 108a, 108b, 108c, 108d de la maille soit en contact électrique avec une borne 107a, 107b, 107c, 107d associée après l'insertion. Afin d'assurer le contact électrique des fils avec les bornes 107a, 107b, 107c, 107d, l'écartement de deux fils consécutifs de chaîne 108a, 108b, ou de trame 108c, 108d, est inférieur à la distance séparant deux zones de contact associées opposées entre les fils et les bornes. Dans l'exemple de la figure 10, l'élément en saillie 103 est de section circulaire, l'écartement de deux fils consécutifs de chaîne, ou de trame, est inférieur au diamètre de l'élément en saillie 103. Autrement dit, les fils 108a, 108b, 108c, 108d de la maille sont tous sollicités contre l'élément en saillie 103 et en contact avec ce dernier.

Selon une variante vue de côté de la figure 10 illustrée à la figure 11, le tissu peut comporter une épaisseur importante, et des fils de chaîne et de trame de différentes mailles peuvent être empilés les uns au-dessus des autres. Ainsi, il est possible que les quatre fils électriquement conducteurs définis à la figure 10 proviennent de différentes mailles d'étages différents. Sur la figure 11, seuls les fils électriquement conducteurs 108a, 108b, 108c, 108d ont été représentés. Ces fils 108a, 108b, 108c, 108d sont chacun sollicités en contact électrique avec des bornes associées non représentées de l'élément en saillie 103 avant déformation.

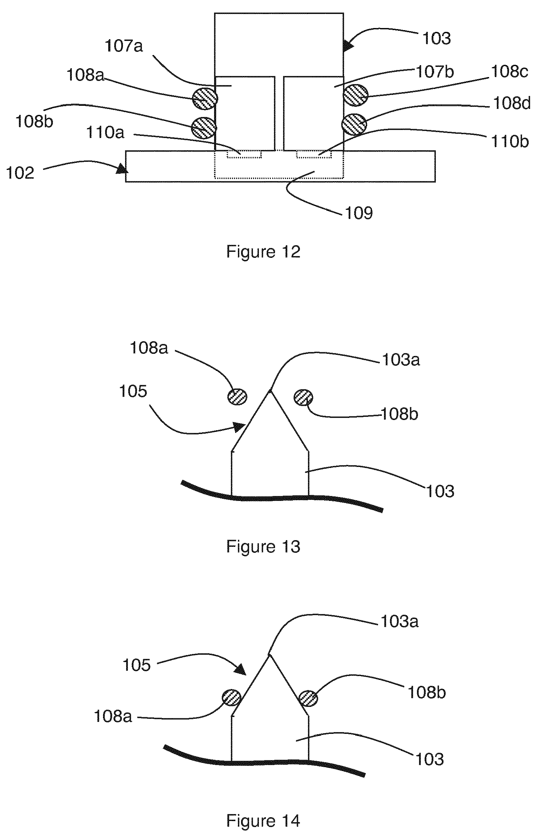

Sur la figure 12 qui est une variante de la figure 9 pour laquelle de mêmes références désignent de mêmes éléments, de mêmes bornes de connexion 107a, 107b peuvent être associées électriquement à plusieurs fils électriquement conducteurs 108a, 108b, 108c, 108d. Ainsi, sur cette figure 12, les fils 108a et 108b sont en contact électrique avec la borne de connexion 107a et les fils 108c, 108d sont en contact électrique avec la borne 107b. Ceci permet d'augmenter la fiabilité de l'assemblage par redondance des connexions électriques. Ce principe peut aussi s'appliquer aux autres modes de réalisation et variantes décrites ci-dessus.

Selon une variante (non représentée), l'élément en saillie peut comporter plusieurs bornes de connexion espacées les unes des autres selon la hauteur de l'élément en saillie. En fait, l'élément en saillie peut être structuré en utilisant un PCB multicouches dont certaines pistes électriquement conductrices sont reliées entre elles de sorte à créer plusieurs bornes de connexion décalées le long de l'élément en saillie selon sa direction axiale. Dès lors, selon cette variante, les fils 108a, 108b, 108c, 108d de la figure 12 pourraient chacun être associés à une borne de connexion distincte.

De préférence, lorsqu'une borne de connexion est située sur la face de l'embase 102 au niveau de laquelle s'élève l'élément en saillie 103 (modes de réalisation des figures 7 et 8), la borne de connexion 107 associée à l'élément en saillie déformé permettent de générer un pincement mécanique pour maintenir le contact électrique entre le fil associé et la borne de connexion selon l'axe X. Autrement dit, le fil électriquement conducteur correspondant est maintenu en contact électrique avec la borne associée grâce à une compression du tissu entre le bourrelet 106 et l'embase 102. Lorsqu'une borne est formée sur l'embase, le tissu est préférentiellement tissé, ou agencé, de sorte que le fil électriquement conducteur destiné à coopérer avec la borne associée soit disposé sur la face extérieure 104a du tissu par laquelle le dispositif à puce sera inséré. Ceci permet de faciliter le contact électrique d'un fil avec sa borne associée en évitant l'interposition de fils ou de fibres du tissu qui pourraient gêner le contact électrique.

De préférence, lorsque la borne est située sur l'élément en saillie (figure 9), le fil électriquement conducteur associé est maintenu en contact électrique grâce à la densité du tissu qui maintient ce contact. Dans le cadre d'une maille, on dira que deux fils consécutifs parallèles enserrent l'élément en saillie, au moins un des deux fils étant électriquement conducteurs et pouvant alors être en contact électrique avec une borne de connexion associée. Dans ce cas, un fil électriquement conducteur du tissu destiné à venir en contact avec la borne peut être en surface du tissu ou entouré d'autres fils dans le tissu. Dans le cas où le fil électriquement conducteur est à la surface de la face du tissu opposée à la face du tissu en contact avec l'embase, le maintien du fil électriquement conducteur contre sa borne de connexion peut aussi être réalisé par le bourrelé de sertissage qui a au moins flué partiellement autour dudit fil électriquement conducteur lors de sa déformation.

Comme évoqué ci-dessus, l'élément en saillie peut présenter une forme pénétrante, le long de l'axe X perpendiculaire au plan de l'embase, définie au moins par son extrémité libre. Cette forme pénétrante est avantageuse notamment pour faciliter l'insertion du dispositif à puce dans un tissu comportant deux fils électriquement conducteurs et sensiblement parallèles. Ainsi, l'extrémité libre de l'élément en saillie présente une dimension inférieure à l'écartement des deux fils. Les figures 13 et 14 illustrent partiellement l'extrémité libre 105 de l'élément en saillie 103 et le comportement de deux fils 108a, 108b du tissu (pour des raisons de clarté, seuls deux fils parallèles du tissu ont été représentés). Sur la figure 13, lors de l'insertion de l'extrémité libre 105 de l'élément en saillie 103, préférentiellement en pointe, cette dernière est approchée du tissu pour être placée entre les deux fils 108a, 108b. Ensuite (figure 14), le dispositif à puce est déplacé entre les deux fils électriquement conducteurs 108a, 108b de sorte qu'ils soient écartés par la forme pénétrante de l'élément en saillie 103 de part et d'autre de son sommet. En fait, les fils 108a, 108b viennent prendre appui le long du corps de l'élément en saillie 103 de part et d'autre de son sommet 103a puis suivent la surface extérieure du corps de l'élément en saillie 103. Le déplacement du dispositif à puce est continué jusqu'à ce que les deux fils 108a, 108b viennent chacun en contact électrique avec une borne de connexion associée du dispositif à puce (étape non représentée). Dans le cas où un seul de ces deux fils parallèles est électriquement conducteur, il vient en contact avec sa borne de connexion associée, les deux fils permettent alors de maintien du contact électrique.

Afin de réaliser la fonction de la forme pénétrante de l'élément en saillie, ce dernier peut avoir une section trapézoïdale, la base du trapèze est raccordée à l'embase, tandis que le sommet du trapèze forme l'extrémité libre de l'élément en saillie.

L'homme du métier pourra utiliser toute autre forme favorisant l'insertion de l'extrémité libre de l'élément en saillie dans le tissu, par exemple une forme en pyramide, une forme en cône tronqué ou non, etc.

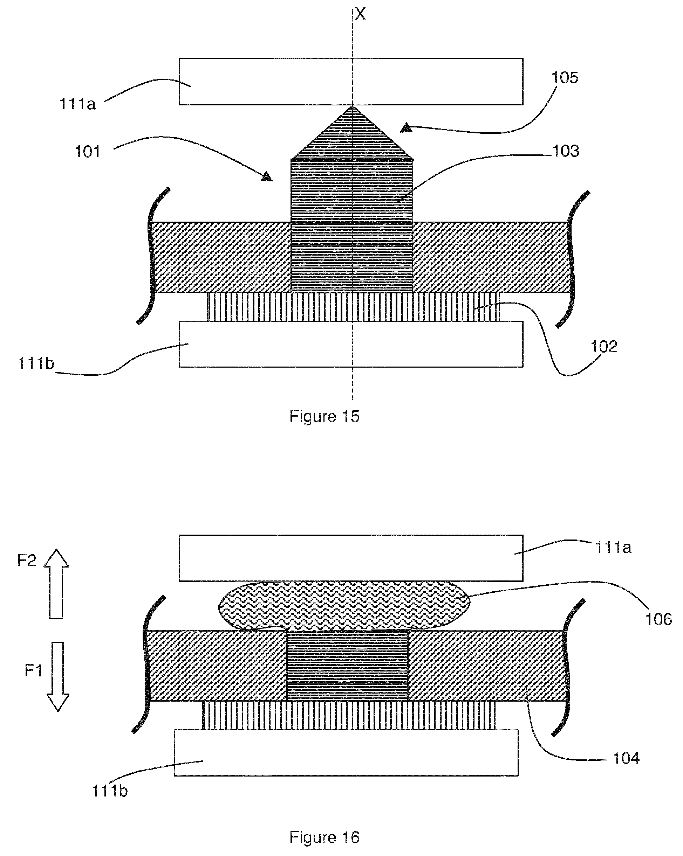

Selon une mise en oeuvre préférentielle du procédé d'assemblage illustrée à la figure 15, l'étape de déformation est réalisée en reportant, de part et d'autre du dispositif à puce 101, deux platines 111 a, 111 b pour appliquer via ces platines 111 a, 111 b un effort de compression axial (selon l'axe X) sur l'élément en saillie 103 entre son extrémité libre 105 et sa jonction avec l'embase 102. Avantageusement, une première platine 111a est placée en contact avec l'extrémité libre 105 de l'élément saillie 103, une seconde platine 111 b peut être placée en contact avec l'embase 102. Les platines peuvent ensuite être rapprochées pour déformer l'élément en saillie 103 et générer le bourrelet de sertissage, par exemple par déformation à chaud ou à froid, ou encore par chaleur apportée par voie ultrasonore.

La voie ultrasonore permet la transformation d'oscillations électriques en oscillations mécaniques pour échauffer et fondre localement le matériau formant l'extrémité libre de l'élément en saillie. Les oscillations mécaniques peuvent être transmises audit matériau à l'aide d'une sonotrode mise en contact avec ladite extrémité libre qui entraîne alors son échauffement. Il est implicite que l'embase est plus résistante à la déformation que l'élément en saillie. Autrement dit de manière générale, l'étape de déformation peut comprendre le maintien du dispositif à puce, par exemple via la platine 11 b, dont l'élément en saillie 103 traverse le tissu 104, et la déformation par voie ultrasonore de l'extrémité libre 105 de l'élément en saillie 103 par exemple via la platine 111 a.

Afin de favoriser la déformation de l'élément en saillie 103, ce dernier est formé, au moins au niveau de son extrémité libre 105, par un matériau thermodéformable (par exemple un polymère thermoplastique ou thermodurcissable). Dès lors, la platine 111 a en contact avec l'élément en saillie 103 peut être chauffée lors de l'étape de déformation pour venir chauffer l'extrémité libre de l'élément en saillie 103 et favoriser son fluage pour générer un bourrelet de sertissage 106 comme illustré à la figure 16. Dans le cas où le dispositif à puce ne traverserait pas le tissu (mode de réalisation de la figure 5), il est possible de compresser les deux platines 111a, 111b de sorte à comprimer le tissu jusqu'à ce que la platine chauffante vienne en contact avec l'extrémité libre 105. Bien entendu, en ce qui concerne la température appliquée, l'homme du métier choisira la température idoine en fonction du matériau formant l'extrémité libre 105 de l'élément en saillie 103.

Le matériau utilisé peut être choisi parmi ceux du tableau ci-dessous :

| **Polymère** | **Acronyme** | **Tg (°C)** | **Tm (°C)** |
|---|---|---|---|
| Cyclic Olefin Copolymer | COC | 70 - 155 | 190 - 320 |
| Polymethylmethacrylate | PMMA | 100 - 122 | 250 - 260 |
| Polycarbonate | PC | 145 - 148 | 260 - 270 |
| Polystyrene | PS | 92 - 100 | 240 - 260 |

où Tg représente la température de transition vitreuse, c'est-à-dire la température de ramollissement de la matière, et Tm représente la température de fusion.

Avantageusement, l'élément en saillie (105) est formé, au moins au niveau de son extrémité libre 105, par un matériau dont la température de fusion est comprise entre 70°C et 320°C

Dans l'exemple de réalisation où l'élément en saillie ne traverse pas le tissu, la première platine peut être placée en contact avec une face du tissu au niveau d'une portion de tissu séparant ladite face du tissu de l'extrémité libre de l'élément en saillie. Dans ce cas, cette face de tissu est celle opposée à la face d'insertion. La température de la platine chauffante peut alors être transmise par la portion de tissu à l'extrémité libre de l'élément en saillie située dans le tissu.

Selon une mise en oeuvre prise en combinaison avec la platine 111a chauffante, la platine 111 b, placée en contact avec l'embase (typiquement sur la face de l'embase opposée à la face où s'élève l'élément en saillie 103), est refroidie au cours de l'étape de déformation. Cette mise en oeuvre est avantageuse notamment lorsque l'élément en saillie 103 est entièrement réalisé dans un même matériau thermodéformable. En effet, dans ce cas particulier la platine 111b permet de maintenir une partie de l'élément en saillie 103 proximale de l'embase à une température empêchant sa déformation de sorte que seule l'extrémité libre 105 de l'élément en saillie 103 se déforme. Si la platine 111 b n'est pas refroidie, l'élément en saillie 103 sera préférentiellement réalisé en deux parties, une première partie proximale de l'embase est alors en un matériau plus résistant à la déformation et à la chaleur qu'une seconde partie de l'élément en saillie située dans le prolongement de la première partie et formant au moins l'extrémité libre de l'élément en saillie 105. Les matériaux visés dans le tableau ci-dessus pourront être choisis selon les critères énumérés précédemment. Ces deux parties de l'élément en saillie peuvent aussi avoir des propriétés mécaniques différentes dans le cas où on déforme l'élément en saillie sans avoir à le chauffer.

Le dispositif à puce peut être réalisé en deux parties. Une première partie comprend l'embase incluant, ou formant, la puce, ou l'embase sur laquelle est montée la puce (la puce fait alors saillie de l'embase). La deuxième partie correspond alors à l'élément en saillie, ou à une portion de l'élément en saillie destinée à former, avec la puce montée sur l'embase, l'élément en saillie. La deuxième partie peut être obtenue par injection de matière dans un moule idoine ou par usinage d'une pièce. Selon une mise en oeuvre, la deuxième partie peut être collée sur la première partie. Selon une autre mise en oeuvre, le matériau destiné à former la deuxième partie est disposé dans un moule sur lequel la première partie est reportée de sorte à être en contact avec le matériau. Le matériau est alors liquéfié, par exemple par chauffage, puis refroidi de sorte à adhérer à la première partie et former un nouvel ensemble constituant le dispositif à puce.

Le dispositif à puce peut comporter une diode électroluminescente ou offrir tout autre type de fonction réalisable par la puce. Lorsque le bourrelet de sertissage est disposé en surface extérieure du tissu, il permet avantageusement de maintenir les fibres à l'écart du sommet dudit bourrelet. Ainsi, lorsque le dispositif à puce comporte une diode, cette dernière peut émettre de la lumière par le sommet du bourrelet de sertissage sans que la propagation de cette lumière ne soit gênée par les fibres du tissu. Dans ce cas, l'élément en saillie est transparent. Ainsi, en plaçant judicieusement plusieurs dispositifs à puce dans un tissu, il est possible de réaliser des motifs précis et d'alimenter ces dispositifs à puce par des fils électriquement conducteurs. Il est aussi possible d'insérer des dispositifs de type RFID dans un ruban tissé, les antennes desdits dispositifs étant alors réalisées par des fils électriquement conducteurs du tissu, par exemple en cuivre.

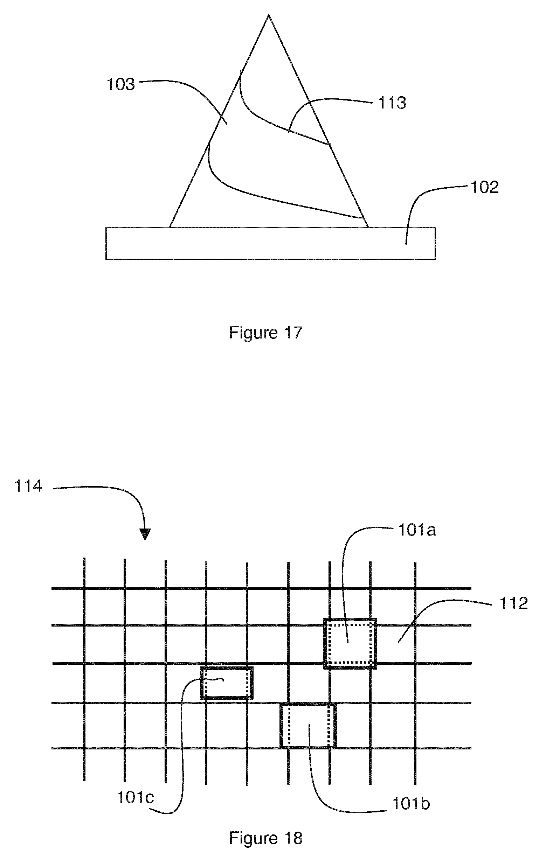

Selon une variante, illustrée à la figure 17, la forme de l'élément en saillie 103 est conique (tronquée ou non), et l'élément en saillie 103 comporte un filetage à deux filets 113. Ainsi, l'insertion du dispositif à puce dans le tissu peut être réalisé en mettant les filets en prise avec deux fils du tissu (préférentiellement deux fils parallèles d'une même maille), et en appliquant un mouvement de vissage au dispositif à puce 101. Le vissage peut être réalisé jusqu'à ce que l'embase 102 vienne en contact avec le tissu et/ou dans le cas où au moins un des deux fils est électriquement conducteur, que ce fil électriquement conducteur vienne en contact électrique avec une borne de connexion associée.

La figure 18 illustre un tissu 104 comprenant une pluralité de mailles 112. Trois dispositifs à puce 101 a, 101b, 101 c sont incorporés. Le dispositif à puce 101 a le plus à droite est relié électriquement à quatre fils d'une même maille. Les deux autres dispositifs à puce 101b, 101 c sont chacun reliés électriquement à deux fils de maille. À la figure 18, des fils de trame et des fils de chaîne ont été représentés perpendiculaires et les pas séparant deux fils parallèles ont été représentés sensiblement égaux de sorte que les mailles sont carrées. Bien entendu, les orientations des fils et les pas de chaîne et de trame peuvent être quelconques sans que cela n'affecte l'utilisation de dispositifs à puce de dimensions et de formes adaptées au tissu. De manière générale, qu'il y ait connexion électrique ou non, un tissu comporte au moins un dispositif à puce serti au niveau dudit tissu, que le bourrelet de sertissage soit extérieur au tissu ou dans le tissu. Par définition, le sertissage s'entend par fixer une pièce sur une autre en rabattant le rebord une première pièce sur la seconde ou dans des évidements de la seconde. Dans le cas présent, la première pièce est le dispositif à puce et la seconde pièce le tissu, les évidements du tissu sont considérés comme étant les espaces libres des mailles ou entre les fibres du tissu et le rebord est défini par au moins une partie de l'élément en saillie.

De tels dispositifs peuvent aussi être insérés dans des vêtements intelligents afin de suivre l'évolution d'une personne tant sur le plan géographique que sur le plan médical.

Les dispositifs à puce peuvent avoir des dimensions inférieures à 5 mm de côté, l'épaisseur du dispositif à puce une fois serti au tissu peut être inférieure à 200 µm. Les dispositifs peuvent alors être insérés dans un tissu en utilisant des machines classiques de manipulation de petits objets. Le procédé d'insertion dans un tissu peut dès lors être mis en place à faible coût.

De nombreuses variantes et modifications des modes de réalisation décrits ici apparaîtront à l'homme du métier. On décrit des formes pénétrantes prismatique, pyramidale et conique, mais toute autre forme convexe peut convenir du moment qu'elles facilitent la pénétration dans le tissu.

Comme indiqué précédemment, le rôle de la déformation est de maintenir l'assemblage entre le tissu et le dispositif à puce après déformation. Selon une variante non représentée, le dispositif à puce peut comporter une ou des rainures dans lesquelles des fibres ou fils du tissu peuvent venir se loger lors de l'insertion, ces rainures permettent d'améliorer le maintien. Les rainures peuvent être formées dans l'élément en saillie ou délimitées par l'élément en saillie et une portion de l'embase à la jonction entre l'élément en saillie et l'embase.

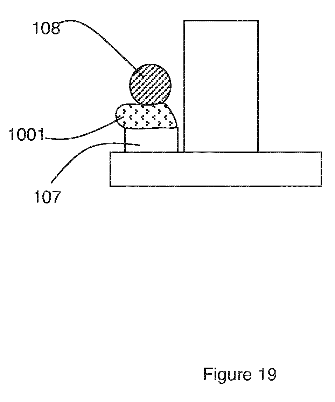

Selon un perfectionnement applicable à tous les modes de réalisation, et illustré schématiquement à la figure 19, où l'on souhaite associer un fil électriquement conducteur 108 du tissu à une borne de connexion 107 reliée à la puce d'un dispositif à puce, un polymère 1001 peut être interposé entre le fil 108 et la borne de connexion 107. Un tel polymère 1001 est destiné à assurer un contact électrique entre ledit fil 108 et ladite borne 107. Cette interposition est, de préférence, réalisée avant l'étape d'insertion.

Selon une mise en oeuvre, le polymère comprend des particules électriquement conductrices. Dès lors, le procédé peut comprendre les étapes suivantes :
- une étape de sollicitation du fil 108 contre la borne de connexion électrique 107 pour pincer au moins une particule, ou un agglomérat de particules, entre la borne de connexion 107 et le fil 108,
- et une étape de solidification du polymère 1001 pour assurer un maintien mécanique entre le fil 108, le polymère 1001 solidifié et la borne de connexion 107, de sorte à assurer après solidification le contact électrique entre le fil 108 et la borne 107.

Autrement dit, le polymère 1001 chargé en particules est disposé au moins niveau d'une borne de connexion 107 et du fil 108 associé que l'on souhaite connecter à ladite borne. Par « au niveau », on entend qu'au moins une portion du polymère 1001 est interposée entre le fil 108 et la borne de connexion 107.

La sollicitation peut être réalisée par une pression appliquée par le fil 108 en direction de la borne 107 ou inversement, pour compresser la portion du polymère 1001 située entre la borne de connexion 107 et le fil 108. Il résulte de cette pression une mise en contact électrique entre la borne de connexion 107 et le fil 108 associé via au moins une particule. En fait, à l'origine dans le polymère les particules sont uniformément réparties mais ne se touchent pas, la pression permet une accumulation des particules de sorte à ce que statistiquement au moins une particule ou un agglomérat de particules soit pincé. Un agglomérat correspond en fait à une pluralité de particules en contact électrique les unes avec les autres. Une fois la pression appliquée, le polymère est figé, par exemple par recuit, pour maintenir l'assemblage et le contact électrique ainsi formé entre le fil et la borne de connexion associée.

Ce perfectionnement a pour avantage d'améliorer le contact électrique décrit ci-dessus tout en améliorant le maintien du dispositif à puce dans le tissu déjà en partie assuré par la déformation de l'élément en saillie.

Parmi les types de polymères envisageables dans le cadre de la favorisation d'un contact électrique, il est possible d'utiliser des colles conductrices anisotropiques. Les polymères pourront alors être de type film anisotropique conducteur (ACF pour « Anisotropic Conductive Film » en anglais), adhésif anisotropique conducteur (ACA pour « Anisotropic Conductive Adhesive » en anglais), adhésif isotropique conducteur (ICA pour « Isotropic Conductive Adhesive » en anglais). Le polymère peut imprégner le tissu avant ou après l'insertion de l'élément en saillie du dispositif à puce.

Selon une réalisation particulière, le polymère une fois durci peut suffire à maintenir le dispositif à puce avec le tissu. Autrement dit, l'étape de déformation de l'élément en saillie n'est plus nécessaire. Dans ce cas, si le dispositif à puce ne nécessite pas de connexion électrique avec le tissu le polymère pourra avoir une simple fonction de solidarisation de l'assemblage. Dès lors, le procédé peut comprendre les étapes suivantes : prévoir un dispositif à puce micro-électronique comprenant une embase et un élément en saillie s'élevant d'une face de l'embase, ledit élément en saillie comprenant une extrémité libre opposée à l'embase ; insérer dans le tissu, à partir d'une face du tissu, le dispositif à puce par l'extrémité libre de l'élément en saillie ; fixer par l'utilisation d'un polymère le dispositif à puce avec le tissu pour assurer le maintien du dispositif à puce dans le tissu. Le polymère peut alors être une simple colle. Bien entendu, cette réalisation particulière peut être combinée avec l'utilisation d'un polymère pour assurer un contact électrique tel que défini ci-dessus entre notamment un fil électriquement du tissu et une borne de connexion électrique du dispositif à puce, la seule différence restant que l'étape de déformation n'est pas réalisée.

Il a été précisé ci-avant comment le dispositif à puce 101 pouvait être intégré à un tissu 104 de sorte à être serti au niveau du tissu par un bourrelet de sertissage 106.

Selon une mise en oeuvre particulière applicable aux différents modes de réalisation, le tissu 104 est un tissu imperméable aux liquides par exemple à l'eau, notamment l'eau de pluie. En fait, par imperméable, on entend que le tissu peut, par exemple, former un sac étanche qui plongé dans l'eau empêche l'eau de pénétrer à l'intérieur du sac par exemple après 5 minutes d'immersion sous l'eau. L'insertion du dispositif à puce par son extrémité libre altère le tissu au niveau de l'insertion. Il résulte donc qu'après l'étape d'insertion le tissu n'est plus imperméable localement, ceci risquant d'engendrer une problématique quant à l'étanchéité du tissu. Pour résoudre cette problématique, il est possible, après l'étape de déformation de l'élément en saillie 105, de prévoir une étape d'étanchéification par dépôt d'un matériau au niveau de l'altération du tissu de sorte à rendre étanche l'assemblage du dispositif à puce 101 avec le tissu 104. Avantageusement, ce matériau peut aussi être déposé du côté de l'interface de l'embase 102 avec le tissu 104, ceci permettant notamment d'éviter les accroches. De manière avantageuse, cette étape d'étanchéification est réalisée concomitamment à l'étape de déformation. Pour cela, le matériau utilisé pour former l'élément en saillie 105 permet, après déformation, de réaliser l'étanchéité de l'assemblage du tissu 104 avec le dispositif à puce 101. Autrement dit, la déformation de l'élément en saillie 105 au niveau de son extrémité libre permet, après déformation, d'assurer le maintien du dispositif à puce 101 et l'étanchéité de l'assemblage. Pour réaliser l'étanchéité de l'assemblage tissu/dispositif à puce, l'étape de déformation de l'élément en saillie 105 aura avantageusement comme conséquence de faire fluer, et avantageusement faire fondre, au moins partiellement l'élément en saillie 105 de sorte que ce dernier puisse, après déformation, enduire le tissu 104 au niveau de la zone de pénétration du dispositif à puce 101 dans le tissu 104 de sorte à combler les interstices et altérations formés dans le tissu 104 par l'étape d'insertion. Selon une variante pouvant être prise en combinaison avec ce qui a été dit ci-dessus, la face de l'embase opposée au tissu peut aussi comporter un matériau thermodéformable (par exemple un polymère thermoplastique ou thermodurcissable), de sorte que ce matériau soit aussi déformé pour assurer l'étanchéité au niveau de l'interface de l'embase avec le tissu.

Autrement dit, un tissu peut comprendre au moins un dispositif à puce serti au niveau du tissu par un bourrelet de sertissage, et, avantageusement, il s'agit d'un tissu étanche. Dans ce cas, au niveau du dispositif à puce, l'étanchéité est garantie, totalement, ou au moins partiellement, par le bourrelet de sertissage.

Il a été précisé précédemment, que le dispositif à puce pouvait comporter une diode électroluminescente et pouvait, après sertissage, émettre de la lumière par le sommet du bourrelet issu de l'étape de déformation. Autrement dit, le bourrelet de sertissage 106 est configuré de sorte à former une lentille optique par laquelle la lumière issue de la diode électroluminescente est émise. Ainsi, avantageusement, l'étape de déformation comporte une étape de conformation d'un bourrelet de sertissage sous une forme de lentille optique, par exemple une lentille de Fresnel. Cette conformation peut être réalisée grâce à une platine comprenant une empreinte dans laquelle l'élément en saillie 105 flue au moins partiellement lors de l'étape de déformation. Cette réalisation à base de diode peut être combinée avec la problématique de l'étanchéité vue ci-dessus.

En outre, le bourrelet de sertissage 106 peut aussi adopter toute forme permettant d'afficher un motif ou de présenter une information. Selon un exemple particulier, le bourrelet de sertissage 106 forme un dôme dont la base est définie par un cercle de rayon R, et ce dôme comporte une hauteur H par rapport à la base du dôme de sorte que le rapport H/R soit compris entre 0,7 et 1,3. La base du dôme est reliée à l'embase au moins par une portion résiduelle de l'élément en saillie. Un tel rapport permet une meilleure diffusion de la lumière. Avantageusement, la portion résiduelle comporte, selon une section transversale (dans un plan parallèle au plan comportant l'embase), un contour extérieur en forme de cercle, de sorte que le diamètre dudit cercle est sensiblement trois fois inférieur au diamètre de la base du dôme.

Il a aussi été précisé ci-avant que l'élément en saillie pouvait être formé au moins au niveau de son extrémité libre par un matériau thermodéformable. Dès lors, de manière générale, l'étape de déformation peut être réalisée par chauffage de ladite extrémité libre. Tout dispositif de chauffage peut alors être mis en oeuvre comme par exemple la ou les platines décrites précédemment.

Dans la variante où le dispositif à puce comporte une rainure, la déformation de l'élément en saillie permet aussi de fixer le fil dans une rainure où il a été inséré lors de l'étape d'insertion du dispositif à puce dans le tissu.

## Revendications

1. Procédé d'assemblage d'un dispositif à puce (101) micro-électronique dans un tissu (104), **caractérisé en ce qu'**il comprend les étapes suivantes :
• prévoir un dispositif à puce (101) micro-électronique comprenant une embase (102) et un élément en saillie (103) s'élevant d'une face de l'embase (102), ledit élément en saillie comprenant une extrémité libre (105) opposée à l'embase (102),
• insérer dans le tissu (104), à partir d'une face (104a) du tissu (104), le dispositif à puce (101) par l'extrémité libre (105) de l'élément en saillie (103),
• déformer l'élément en saillie (103) au niveau de son extrémité libre (105) de sorte à former un bourrelet de sertissage afin d'assurer le maintien du dispositif à puce (101) avec le tissu (104) après déformation.

2. Procédé selon la revendication 1, **caractérisé en ce que** le dispositif à puce (101) comporte une borne de connexion électrique (107) reliée à la puce (109), et **en ce que** le tissu (104) comporte un fil électriquement conducteur (108), ledit fil électriquement conducteur (108) étant amené en contact électrique avec la borne de connexion (107) lors de l'insertion du dispositif à puce (101) dans le tissu (104), et étant maintenu en contact avec la borne de connexion (107) consécutivement à l'étape de déformation de l'élément en saillie (103).

3. Procédé selon l'une des revendications précédentes, **caractérisé en ce que** l'étape de déformation est réalisée en reportant, de part et d'autre du dispositif à puce (101), deux platines (111a, 111b) pour appliquer via ces platines (111a, 111b) un effort de compression axial (X) sur l'élément en saillie (103) entre son extrémité libre (105) et sa jonction avec l'embase (102).

4. Procédé selon la revendication 3, **caractérisé en ce que** l'élément en saillie (103) est formé, au moins au niveau de son extrémité libre (105), par un matériau thermodéformable, et **en ce qu'**une des platines (111a) est placée en contact avec l'extrémité libre (105) de l'élément en saillie (103), ou en contact avec une face de tissu séparée de l'extrémité libre (105) par une portion de tissu, pour venir chauffer ladite extrémité libre (105) au cours de l'étape de déformation.

5. Procédé selon la revendication 4, **caractérisé en ce que** l'autre platine (111b) est placée en contact avec l'embase (102) sur une face de l'embase (102) opposée à la face de l'embase (102) sur laquelle s'élève l'élément en saillie (103), cette autre platine (111b) étant refroidie lors de l'étape de déformation.

6. Procédé selon l'une quelconque des revendications précédentes **caractérisé en ce que** le tissu comporte deux fils électriquement conducteurs (108a, 108b) et sensiblement parallèles, et **en ce que** l'élément en saillie (103) présente une forme pénétrante, le long d'un axe (X) perpendiculaire au plan de l'embase (102), définie au moins par l'extrémité libre (105) de l'élément en saillie (103) ayant une dimension inférieure à l'écartement des fils (108a, 108b), l'étape d'insertion du dispositif à puce (101) dans le tissu (104) comportant les sous-étapes suivantes :
- placer l'extrémité libre (105) de l'élément en saillie (103) entre les deux fils (108a, 108b),
- déplacer le dispositif à puce (101) entre les deux fils d'où il résulte que les fils (108a, 108b) sont écartés par la forme pénétrante de l'élément en saillie (103),
- continuer le déplacement du dispositif à puce jusqu'à ce que les deux fils (108a, 108b) viennent chacun en contact électrique avec une borne (107a, 107b) de connexion associée du dispositif à puce (101).

7. Procédé selon l'une quelconque des revendications 1 à 5, **caractérisé en ce que** la forme de l'élément en saillie (103) est conique, et **en ce que** l'élément en saillie (103) comporte un filetage à deux filets, le procédé comprenant lors de l'étape d'insertion les étapes suivantes :
• mettre les filets en prise avec deux fils (108a, 108b) du tissu (104), et
• appliquer un mouvement de vissage au dispositif à puce (101).

8. Procédé selon la revendication 1, **caractérisé en ce que** l'étape de déformation comporte :
- le maintien du dispositif à puce dont l'élément en saillie (103) traverse le tissu (104),
- la déformation par voie ultrasonore de l'extrémité libre (105) de l'élément en saillie (103).

9. Procédé selon la revendication 1, **caractérisé en ce que** le dispositif à puce (101) comporte une borne de connexion électrique (107) reliée à la puce (109), et **en ce que** le tissu (104) comporte un fil électriquement conducteur (108), ledit procédé comportant une étape d'interposition d'un polymère (1001) destiné à assurer un contact électrique entre le fil (108) et la borne de connexion électrique (107).

10. Procédé selon la revendication 9, **caractérisé en ce que** le polymère (1001) comprend des particules électriquement conductrices, et **en ce que** le procédé comporte :
- une étape de sollicitation du fil (108) contre la borne de connexion électrique (107) pour pincer au moins une particule, ou un agglomérat de particules, entre la borne de connexion (107) et le fil (108),
- et une étape de solidification du polymère (1001) pour assurer un maintien mécanique entre le fil (108), le polymère (1001) solidifié et la borne de connexion (107).

11. Procédé selon l'une quelconque des revendications précédentes, **caractérisé en ce que** le dispositif à puce (101) étant une diode électroluminescente configurée pour émettre de la lumière par le sommet du bourrelet de sertissage (106), l'étape de déformation comporte une étape de conformation du bourrelet de sertissage (106) sous une forme de lentille optique.

12. Dispositif comprenant une puce et comportant une embase (102) au niveau de laquelle s'élève un élément en saillie (103), **caractérisé en ce que** l'élément en saillie (103) a une extrémité libre (105) opposée à l'embase (102), et **en ce que** l'élément en saillie (105) est formé, au moins au niveau de son extrémité libre (105), par un polymère thermoplastique ou thermodurcissable, ou par un matériau dont la température de fusion est comprise entre 70°C et 320°C, l'élément en saillie (103) étant apte à être déformé au niveau de son extrémité libre (105) de sorte à former un bourrelet de sertissage afin d'assurer, après déformation, le maintien dudit dispositif avec un tissu.

13. Dispositif comprenant une puce selon la revendication 12, **caractérisé en ce qu'**il comporte au moins une borne de connexion (107) formée dans l'élément en saillie (103).

14. Tissu comprenant au moins un dispositif à puce, **caractérisé en ce que** le dispositif à puce est serti au niveau du tissu par un bourrelet de sertissage.

15. Tissu selon la revendication précédente, **caractérisé en ce qu'**il s'agit d'un tissu étanche, et **en ce qu'**au niveau du dispositif à puce, l'étanchéité est garantie au moins partiellement par le bourrelet de sertissage.

16. Tissu selon l'une des revendications 14 ou 15, **caractérisé en ce que** le dispositif à puce (101) comporte une diode électroluminescente, et **en ce que** le bourrelet de sertissage (106) est configuré de sorte à former une lentille optique par laquelle la lumière issue de la diode électroluminescente est émise.

## Patentansprüche

1. Verfahren zur Montage einer Vorrichtung (101) mit einem mikroelektronischen Chip in einem Gewebe (104), **dadurch gekennzeichnet, dass** dieses die folgenden Schritte umfasst:
• Bereitstellen einer Vorrichtung (101) mit einem mikroelektronischen Chip, umfassend eine Basis (102) und ein abstehendes Element (103), das sich von einer Fläche der Basis (102) erhebt, wobei das abstehende Element ein freies Ende (105) umfasst, das der Basis (102) gegenüberliegt,
• Einsetzen, in das Gewebe (104), von einer Fläche (104a) des Gewebes (104) aus, der Chipvorrichtung (101) durch das freie Ende (105) des abstehenden Elements (103),
• Verformen des abstehenden Elements (103) auf der Höhe seines freien Endes (105) derart, dass ein Crimp-Wulst gebildet wird, um den Halt der Chipvorrichtung (101) mit dem Gewebe (104) nach der Verformung sicherzustellen.

2. Verfahren nach Anspruch 1, **dadurch gekennzeichnet, dass** die Chipvorrichtung (101) eine elektrische Anschlussklemme (107) umfasst, die mit dem Chip (109) verbunden ist, und dass das Gewebe (104) einen elektrisch leitfähigen Draht (108) umfasst, wobei der elektrisch leitfähige Draht (108) beim Einsetzen der Chipvorrichtung (101) in das Gewebe (104) in elektrischen Kontakt mit der Anschlussklemme (107) gebracht wird, und nach dem Schritt der Verformung des abstehenden Elements (103) mit der Anschlussklemme (107) in Kontakt gehalten wird.

3. Verfahren nach einem der vorhergehenden Ansprüche, **dadurch gekennzeichnet, dass** der Schritt der Verformung durchgeführt wird, indem auf beiden Seiten der Chipvorrichtung (101) zwei Platten (111a, 111b) angebracht werden, um über diese Platten (111a, 111b) eine axiale Druckwirkung (X) auf das abstehende Element (103) zwischen seinem freien Ende (105) und seiner Verbindung mit der Basis (102) auszuüben.

4. Verfahren nach Anspruch 3, **dadurch gekennzeichnet, dass** das abstehende Element (103), mindestens auf der Höhe seines freien Endes (105), aus einem wärmeverformbaren Material gebildet wird, und dass eine der Platten (111a) in Kontakt mit dem freien Ende (105) des abstehenden Elements (103) oder in Kontakt mit einer Fläche des Gewebes, die von dem freien Ende (105) durch einen Gewebeabschnitt getrennt ist, platziert wird, um zu erreichen, dass das freie Ende (105) während des Schritts der Verformung erwärmt wird.

5. Verfahren nach Anspruch 4, **dadurch gekennzeichnet, dass** die andere Platte (111b) in Kontakt mit der Basis (102) auf einer Fläche der Basis (102) gegenüber der Fläche der Basis (102), auf der sich das abstehende Element (103) erhebt, platziert wird, wobei die andere Platte (111b) während des Schritts der Verformung gekühlt wird.

6. Verfahren nach einem der vorhergehenden Ansprüche, **dadurch gekennzeichnet, dass** das Gewebe zwei elektrisch leitfähige und im Wesentlichen parallele Drähte (108a, 108b) umfasst, und dass das abstehende Element (103) eine penetrierende Form, entlang einer Achse (X) senkrecht zur Ebene der Basis (102), aufweist, die mindestens durch das freie Ende (105) des abstehenden Elements (103) mit einer kleineren Abmessung als der Abstand der Drähte (108a, 108b) definiert wird, wobei der Schritt des Einsetzens der Chipvorrichtung (101) in das Gewebe (104) die folgenden Unterschritte umfasst:
- Platzieren des freien Endes (105) des abstehenden Elements (103) zwischen die beiden Drähte (108a, 108b),
- Verschieben der Chipvorrichtung (101) zwischen den beiden Drähten, woraus resultiert, dass die Drähte (108a, 108b) durch die penetrierende Form des abstehenden Elements (103) auseinandergeschoben werden,
- Fortsetzen der Verschiebung der Chipvorrichtung, bis die beiden Drähte (108a, 108b) jeweils mit einer zugeordneten Anschlussklemme (107a, 107b) der Chipvorrichtung (101) in elektrischen Kontakt gelangen.

7. Verfahren nach einem der Ansprüche 1 bis 5, **dadurch gekennzeichnet, dass** die Form des abstehenden Elements (103) konisch ist, und dass das abstehende Element (103) ein Gewinde mit zwei Gängen umfasst, wobei das Verfahren beim Schritt des Einsetzens die folgenden Schritte umfasst:
• Ineingriffbringen der Gänge mit den zwei Drähten (108a, 108b) des Gewebes (104), und
• Vornehmen einer Schraubbewegung an der Chipvorrichtung (101).

8. Verfahren nach Anspruch 1, **dadurch gekennzeichnet, dass** der Schritt der Verformung umfasst:
- Halten der Chipvorrichtung, deren abstehendes Element (103) das Gewebe (104) durchquert,
- Verformen des freien Endes (105) des abstehenden Elements (103) durch Ultraschall.

9. Verfahren nach Anspruch 1, **dadurch gekennzeichnet, dass** die Chipvorrichtung (101) eine elektrische Anschlussklemme (107) umfasst, die mit dem Chip (109) verbunden ist, und dass das Gewebe (104) einen elektrisch leitfähigen Draht (108) umfasst, wobei das Verfahren einen Schritt des Einfügens eines Polymers (1001) umfasst, das dazu bestimmt ist, einen elektrischen Kontakt zwischen dem Draht (108) und der elektrischen Anschlussklemme (107) sicherzustellen.

10. Verfahren nach Anspruch 9, **dadurch gekennzeichnet, dass** das Polymer (1001) elektrisch leitfähige Teilchen umfasst, und dass das Verfahren Folgendes umfasst:
- einen Schritt des Drückens des Drahts (108) gegen die elektrische Anschlussklemme (107), um mindestens ein Teilchen oder ein Agglomerat von Teilchen zwischen die Anschlussklemme (107) und den Draht (108) zu klemmen,
- und einen Schritt der Verfestigung des Polymers (1001), um einen mechanischen Halt zwischen dem Draht (108), dem verfestigten Polymer (1001) und der Anschlussklemme (107) sicherzustellen.

11. Verfahren nach einem der vorhergehenden Ansprüche, **dadurch gekennzeichnet, dass** die Chipvorrichtung (101) eine Elektrolumineszenzdiode ist, die ausgelegt ist, Licht durch den Kamm des Crimp-Wulsts (106) zu emittieren, wobei der Schritt der Verformung einen Schritt der Ausbildung des Crimp-Wulsts (106) in der Form einer optischen Linse umfasst.

12. Vorrichtung, umfassend einen Chip und umfassend eine Basis (102), auf der Höhe von welcher sich ein abstehendes Element (103) erhebt, **dadurch gekennzeichnet, dass** das abstehende Element (103) ein freies Ende (105) gegenüber der Basis (102) aufweist, und dass das abstehende Element (103), mindestens auf der Höhe seines freien Endes (105), aus einem thermoplastischen oder wärmehärtbaren Polymer oder aus einem Material gebildet ist, dessen Schmelztemperatur zwischen 70°C und 320°C liegt, wobei das abstehende Element (103) geeignet ist, auf der Höhe seines freien Endes (105) derart verformt zu werden, dass ein Crimp-Wulst gebildet wird, um nach der Verformung den Halt der Vorrichtung mit einem Gewebe sicherzustellen.

13. Vorrichtung, umfassend einen Chip nach Anspruch 12, **dadurch gekennzeichnet, dass** diese mindestens eine Anschlussklemme (107) umfasst, die in dem abstehenden Element (103) gebildet ist.

14. Gewebe, umfassend mindestens eine Chipvorrichtung, **dadurch gekennzeichnet, dass** die Chipvorrichtung auf der Höhe des Gewebes durch einen Crimp-Wulst gecrimpt ist.

15. Gewebe nach dem vorhergehenden Anspruch, **dadurch gekennzeichnet, dass** es sich um ein dichtes Gewebe handelt, und dass auf der Höhe der Chipvorrichtung die Dichtheit mindestens teilweise durch den Crimp-Wulst garantiert wird.

16. Gewebe nach einem der Ansprüche 14 oder 15, **dadurch gekennzeichnet, dass** die Chipvorrichtung (101) eine Elektrolumineszenzdiode umfasst, und dass der Crimp-Wulst (106) ausgelegt ist, eine optische Linse zu bilden, durch die das von der Elektrolumineszenzdiode ausgegebene Licht emittiert wird.

## Claims

1. Method for assembling a microelectronic chip device (101) in a fabric (104), **characterized in that** it comprises the following steps:
• providing a microelectronic chip device (101) comprising a base (102) and a protruding element (103) rising from a face of the base (102), said protruding element comprising a free end (105) opposite the base (102),
• inserting into the fabric (104), from a face (104a) of the fabric (104), the chip device (101) by the free end (105) of the protruding element (103),
• deforming the protruding element (103) at its free end (105) so as to form a crimping bead in order to ensure that the chip device (101) is secured with the fabric (104) after deformation.

2. Method according to Claim 1, **characterized in that** the chip device (101) comprises an electrical connection terminal (107) linked to the chip (109), and **in that** the fabric (104) comprises an electrically conductive thread (108), said electrically conductive thread (108) being brought into electrical contact with the connection terminal (107) upon the insertion of the chip device (101) into the fabric (104), and being held in contact with the connection terminal (107) following the step of deformation of the protruding element (103).

3. Method according to one of the preceding claims, **characterized in that** the deformation step is performed by transferring, on either side of the chip device (101), two plates (111a, 111b) for applying, via these plates (111a, 111 b), an axial compression force (X) on the protruding element (103) between its free end (105) and its junction with the base (102).

4. Method according to Claim 3, **characterized in that** the protruding element (103) is formed, at least at its free end (105), by a thermodeformable material, and **in that** one of the plates (111 a) is placed in contact with the free end (105) of the protruding element (103), or in contact with a fabric face separated from the free end (105) by a portion of fabric, in order to heat said free end (105) during the deformation step.

5. Method according to Claim 4, **characterized in that** the other plate (111 b) is placed in contact with the base (102) on a face of the base (102) opposite the face of the base (102) from which rises the protruding element (103), this other plate (111 b) being cooled during the deformation step.

6. Method according to any one of the preceding claims, **characterized in that** the fabric comprises two substantially parallel electrically conductive threads (108a, 108b), and **in that** the protruding element (103) has a penetrating form, along an axis (X) at right angles to the plane of the base (102), defined at least by the free end (105) of the protruding element (103) having a dimension less than the spacing of the threads (108a, 108b), the step of insertion of the chip device (101) into the fabric (104) comprising the following substeps:
- placing the free end (105) of the protruding element (103) between the two threads (108a, 108b),
- moving the chip device (101) between the two threads with the result that the threads (108a, 108b) are spaced apart by the penetrating form of the protruding element (103),
- continuing to move the chip device until the two threads (108a, 108b) each come into electrical contact with an associated connection terminal (107a, 107b) of the chip device (101).

7. Method according to any one of Claims 1 to 5, **characterized in that** the form of the protruding element (103) is tapered, and **in that** the protruding element (103) comprises a twin-thread threading, the method comprising, during the insertion step, the following steps:
• engaging the threads with two threads (108a, 108b) of the fabric (104), and
• applying a screwing motion to the chip device (101).

8. Method according to Claim 1, **characterized in that** the deformation step comprises:
- the securing of the chip device whose protruding element (103) passes through the fabric (104),
- the deformation by ultrasound means of the free end (105) of the protruding element (103).

9. Method according to Claim 1, **characterized in that** the chip device (101) comprises an electrical connection terminal (107) linked to the chip (109), and **in that** the fabric (104) comprises an electrically conductive thread (108), said method comprising a step of interposition of a polymer (1001) intended to ensure an electrical contact between the thread (108) and the electrical connection terminal (107).

10. Method according to Claim 9, **characterized in that** the polymer (1001) comprises electrically conductive particles, and **in that** the method comprises:
- a step of stressing of the thread (108) against the electrical connection terminal (107) to clamp at least one particle, or one agglomerate of particles, between the connection terminal (107) and the thread (108),
- and a step of solidification of the polymer (1001) to ensure mechanical hold between the thread (108), the solidified polymer (1001) and the connection terminal (107).

11. Method according to any one of the preceding claims, **characterized in that**, the chip device (101) being a light-emitting diode configured to emit light through the apex of the crimping bead (106), the deformation step comprises a step of shaping of the crimping bead (106) in an optical lens form.

12. Device comprising a chip and comprising a base (102) from which rises a protruding element (103), **characterized in that** the protruding element (103) has a free end (105) opposite the base (102), and **in that** the protruding element (105) is formed, at least at its free end (105), by a thermoplastic or thermoset polymer, or by a material whose melting point is between 70°C and 320°C, the protruding element (103) being able to be deformed at its free end (105) so as to form a crimping bead to ensure, after deformation, said device to be secured with a fabric.

13. Device comprising a chip according to Claim 12, **characterized in that** it comprises at least one connection terminal (107) formed in the protruding element (103).

14. Fabric comprising at least one chip device, **characterized in that** the chip device is crimped in the fabric by a crimping bead.

15. Fabric according to the preceding claim, **characterized in that** it is a seal-tight fabric, and **in that**, on the chip device, the tightness is guaranteed at least partially by the crimping bead.

16. Fabric according to one of Claims 14 or 15, **characterized in that** the chip device (101) comprises a light-emitting diode, and **in that** the crimping bead (106) is configured in such a way as to form an optical lens through which the light from the light-emitting diode is emitted.
